# EUROPEAN PATENT SPECIFICATION

(11) **EP 0 463 559 B1**
(45) Date of publication and mention of the grant of the patent: **16.04.1997**
(21) Application number: 91110062.6
(22) Date of filing: 19.06.1991
(51) Int. Cl.: H01L 21/48, H01L 23/498, H01L 23/495, H01L 23/485

(54) **Packaged semiconductor device and a manufacturing process therefor**
Verkapselte Halbleiteranordnung und ein Herstellungsverfahren dafür
Dispositif semi-conducteur encapsulé et son procédé de fabrication

(30) Priority: 25.06.1990 JP 165979/90
(43) Date of publication of application: 02.01.1992
(60) Divisional application: 95109303.8
(73) Proprietor: FUJITSU LIMITED, Kawasaki-shi, Kanagawa 211 (JP)
(72) Inventor: Tsuji, Kazuto, Kawasaki-shi, Kanagawa, 211 (JP); Hiraoka, Tetsuya, Kawasaki-shi, Kanagawa, 213 (JP); Aoki, Tsuyoshi, Sagamihara-shi, Kanagawa, 229 (JP); Kasai, Junichi, Kawasaki-shi, Kanagawa, 213 (JP)
(74) Representative: Seeger, Wolfgang, Dipl.-Phys.

(56) References cited:
- EP-A- 0 082 902
- EP-A- 0 263 222
- WO-A-88/06395
- US-A- 3 959 874
- IBM TECHNICAL DISCLOSURE BULLETIN. vol. 20, no. 10, March 1978, NEW YORK US page 3872; E. STEPHANS: 'Pinless Module Connector'
- ELECTRONICS. vol. 58, no. 37, September 1985, NEW YORK US page 20; 'Solder Columns Secure Chip Carriers to Epoxy'

## Description

### BACKGROUND OF THE INVENTION

The present invention generally relates to packaging of semiconductor devices, and more particularly to a packaged semiconductor device that can be produced with a reduced cost.

With the progress of the fabrication process of semiconductor devices, the integration density of integrated circuits formed on a semiconductor chip is increasing ever and ever. With the increase in the integration density, the packages used for accommodating the semiconductor chip is also required to have a capability of providing a large number of interconnections leads in correspondence to the increased number of terminals on the chip.

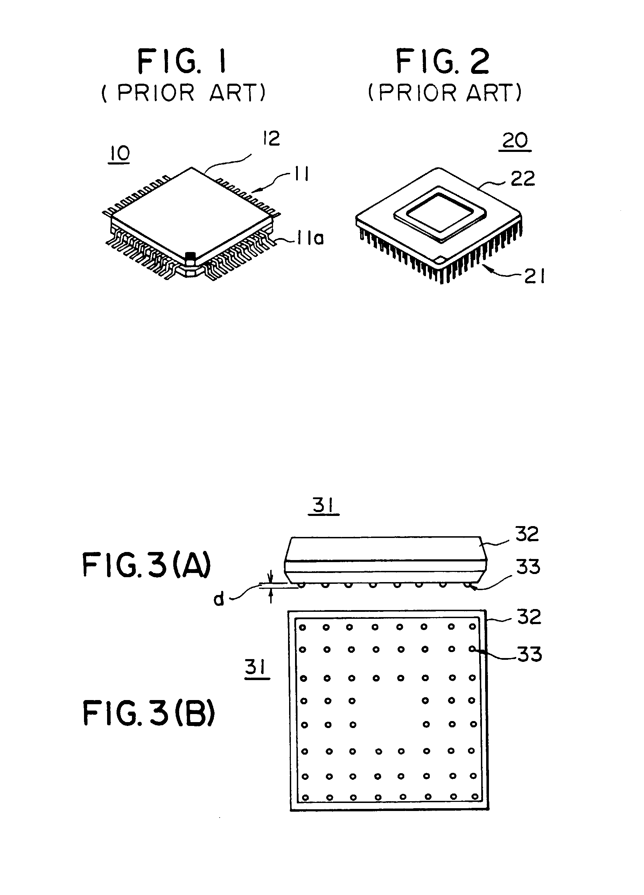

FIG.1 shows a conventional package 10 of the so-called QFP (quad flat package) type wherein a number of leads 11 are provided along the side of a package body 12. The leads 11 project laterally in the outward direction from the package body 12 and bent downward. Further, the leads 11 are bent again in the horizontal direction and form the terminals lla that extend laterally from the body 12. Thereby, a so-called gull-wing type terminal is formed. Obviously, this type of package, having the leads along the side wall of the package body, has a problem of insufficient location for providing the interconnection leads and is not suitable for accommodating semiconductor devices having a large integration density. Further, this type of package tends to show a variation in the vertical level of the terminal part lla of the lead 11. Generally, the level of the terminal lla may change as much as 100 µm. However, such a large variation in the level of the terminal is not desirable from the view point of reliable interconnection.

In order to avoid the problem pertinent to the package of FIG.1, a so-called PGA (pin grid array) package is proposed as shown in FIG.2, wherein a large number of interconnection pins 21 are arranged in rows and columns on the bottom surface of a package body 22. Thereby, one can increase the number of leads on the package body 22 dramatically. For example, leads of as many as several tens in number can be provided without difficulty. This PGA package, on the other hand, has a problem in that a process for embedding the pins 21 on the package body 22 is necessary. Generally, this process includes processes of introducing a large number of minute metal rods on a package body, and apply shaking until the metal rods are settled in the holes formed in the package body as the pins 21. After the pins are settled, it is necessary to fix the pins on the package body 22. Thus, the process for fabricating the PGA package is time consuming and increases the cost of the device.

### SUMMARY OF THE INVENTION

Accordingly, it is a general object of the present invention to provide a novel and useful semiconductor package wherein the foregoing problems are eliminated.

Another object of the present invention is to provide a packaged semiconductor device and a manufacturing method therefore, wherein the cost for manufacturing the device is reduced.

Another object of the present invention is to provide a semiconductor device having a package and a manufacturing method thereof, wherein metal spheres are arranged in a row and column formation on a bottom surface of a package body as interconnection leads.

These objects are achieved by the independent claims.

US-A-3 959 874 describes the use of cylindrical terminal pins embedded in a resin package body of a semiconductor device. This cylindrical pins have the disadvantage that resin is formed on the exposed part of the pins which resin unwandtedly affects the formation of the solder filet on the surface of the pins.

The document IBM TDB vol. 20, no. 10, March 1978, page 3872 describes use of spherical electrodes in combination with a ceramic substrate.

EP-A-0 263 222 discloses a method of forming solder terminals for a pinless ceramic module. The solder terminals are comprised of three integral parts: a bump, a column and a mound of solidified solder.

Other object and further features of the present invention will become apparent from the following detailed description when read in conjunction with the attached drawings.

### BRIEF DESCRIPTION OF THE DRAWINGS

FIG.1 is a perspective view showing a conventional semiconductor device of the OFP type;
FIG.2 is a perspective view showing a conventional semiconductor device of the PGA type;
FIGS.3(A) and 3(B) are diagrams respectively showing the semiconductor device according to a first embodiment of the present invention in the side view and bottom view;
FIGS.4(A) - 4(F) are diagrams showing the process for manufacturing the device of FIGS.3(A) and 3(B);
FIG.5 is a diagram showing the step for establishing the uniform projection of sphere-shaped leads at the bottom surface of the package body for the semiconductor device of FIGS.3(A) and 3(B);
FIGS. 6 and 7 are diagrams showing other embodiments of the present invention.

### DETAILED DESCRIPTION

FIGS.3(A) and 3(B) show a semiconductor device 31 according to a first embodiment of the present invention.

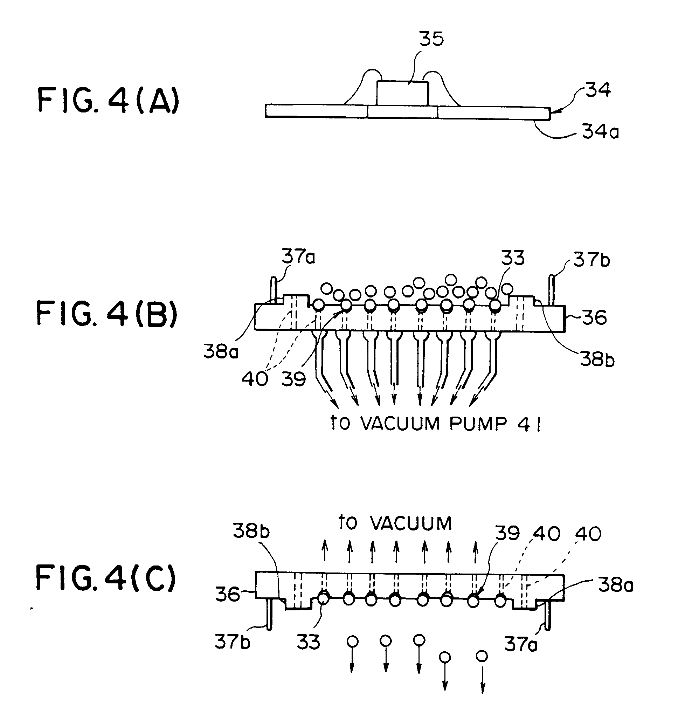

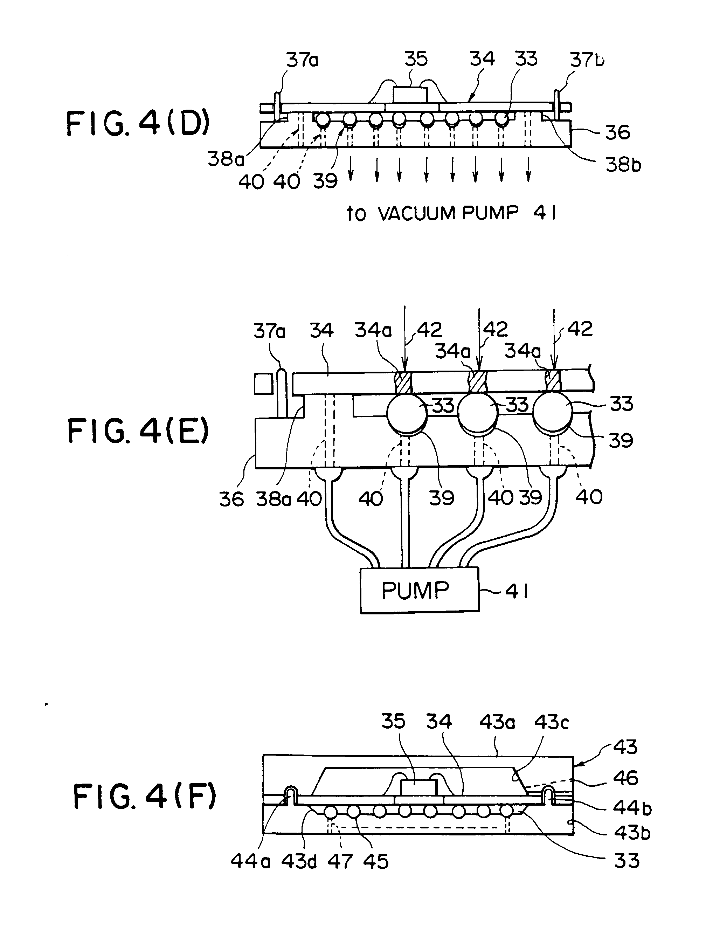

Referring to the drawings, a semiconductor chip 35 (not shown in these drawings, see FIGS.4(A) - 4(C)) is accommodated in a plastic package body 32, and a number of interconnection leads 33 are provided on the bottom surface of the package body 32 similar to the device of the PGA type. In the present embodiment, the interconnection leads are formed from a number of metal spheres arranged in the row and column formation, and projects downward from the bottom surface of the package body 32 by a distance of about 30 µm or less. As will be understood from the description below, the magnitude of projection d is extremely uniform throughout the spheres. The deviation is less than 5 µm, usually less than 1 µm.

FIGS.4(A) - 4(F) show the process for manufacturing the device of FIGS.3(A) and 3(B) according to the first embodiment.

Referring to FIG.4(A), the semiconductor chip 35 mentioned previously is mounted on a lead frame 34. Further, the bonding pads formed on the semiconductor chip 35 are connected to an inner lead 34a of the lead frame 34 by a bonding wire as usual.

Next, the metal spheres 33 each having a same diameter of lmm, for example, are supplied to a jig 36. On the upper major surface of the jig 36, a number of depressions 39 are formed in a row and column formation in correspondence to the row and column formation of the spheres 33 on the bottom surface of the package body 32 shown in FIG.3(B). In correspondence to each depression 39, a hole 10 is formed to penetrate through the body of the jig 36. Upon supplying of the spheres 33 on the jig 36, some spheres settle in the depressions 39 while other spheres cannot find the depression 39 for settling. See FIG.4(B).

In this state, a vacuum is applied at a rear surface of the jig 36 by a vacuum pump 41 (see FIG.4(E)). Thereby, the spheres 33 that are settled in the depressions 39 are held stably on the jig 36.

Next, the jig 36 is turned over as shown in FIG.4(C) and the spheres 33 that have failed settling in the depressions 39 fall off from the jig 36.

Next, the foregoing lead frame 34 is placed on the jig 36 as shown in FIG.4(D). The jig 36 is formed with a support member 38a that extends to surround the region where the depressions 33 is formed, and the lead frame 34 thus placed is held by the support member 38a. In order to establish a proper positioning in the lateral direction, guide pins 37a and 37b are formed on the jig 36, and the guide pins engage with corresponding openings formed on the lead frame 34 when the lead frame 34 is properly positioned. As will be explained in detail later, the uppermost part of the spheres 33 is aligned on a flat plane and is contacted to the flat lower major surface of the lead frame 34 with precision. It should be noted that these metal spheres can be manufactured with high precision. For example, the JIS (Japanese Industrial Standard) prescribes the allowance of diameter of metal spheres be less than 5 µm. The lead frame 34 is held stably on the jig 36 by the air pressure that is caused by the vacuum suction applied to the rear side of the jig 36. It should be noted that the penetrating hole 40 is provided also in correspondence to the support member 38a.

Next, a laser beam 12 is irradiated onto the lead frame 34 in correspondence to where the spheres 33 are located underneath. Thereby, a part 34a of the lead frame 34 is caused to melt to form a fused region 34a that fuses with the metal sphere 33 as shown in FIG.4(E). In other words, a laser welding of the spheres 33 and the lead frame 34 is established.

Next, the lead frame 34 is removed from the jig 36 together with the semiconductor chip 35 as well as the metal spheres 33 that are welded to the lead frame 34, and the lead frame 34 is placed on a second jig 43 as shown in FIG.4(F).

Referring to FIG.4(F), the jig 43 includes an upper mold 43a and a lower mold 43b, wherein the upper and lower molds are formed with spaces 43c and 43d corresponding to the resin package body 32 of the device of FIG.3(A). On the lower mold 43b, a number of depressions 45 are formed in the row and column formation in correspondence to the row and column formation of the metal spheres on the lead frame 34. Further, each depression 45 is evacuated via a hole 47 penetrating through the lower mold 43b. In order to establish a proper positioning of the mold and the lead frame, guide pins 44a and 44b are provided on the lower mold 43b, and corresponding depressions are provided in the upper mold 43a. The pins 44a and 44b may be provided to engage with the openings formed in the lead frame 34 for accommodating the guide pins 37a and 37b of the jig 36.

When the lead frame 34 is properly mounted on the jig 43 and firmly held thereto by the evacuation through the holes 47, a molten plastic is poured into the space 43c and 43d in the jig 43 via a passage 46. After curing the plastic, the jig 43 is removed and the packaged semiconductor device of FIGS.3(A) and 3(B) is obtained.

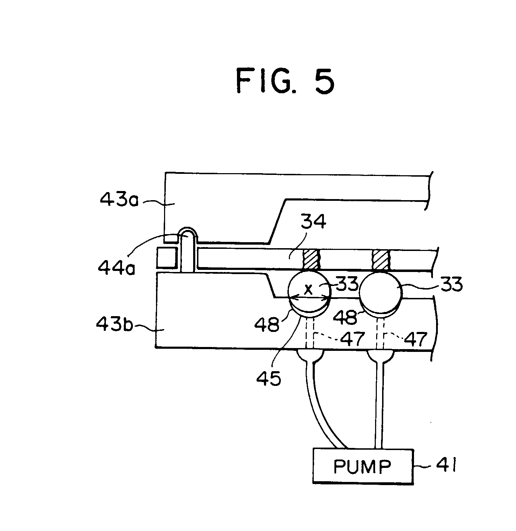

FIG.5 shows the process for achieving a uniform projection d of the spherical leads 33 in the semiconductor device 31. Referring to FIG.5, the depression 45 has a diameter x that is set smaller than the diameter of the spheres 33. Thereby, a space 48 is formed between the sphere 33 and the mold 43b, and this space 48 is evacuated via the penetrating hole 47. As the metal spheres can be manufactured to have a highly uniform diameter with the tolerance of less than 5 pm, typically less than 1 µm, one can determine the vertical positioning level of the spheres 33 on the mold 43b by setting the diameter x of the circular opening formed at the surface of the mold 43b in correspondence to the semi-spherical depression 45. Typically, the variation of the projection d can be set smaller than a few microns. The space 48 of course produces a negative pressure when evacuated via the hole 47 and the lead frame 34 is firmly held on the mold 43b.

According to the process described above, it will be understood that one can easily arrange the leads in the row and column formation in the package body without shaking and/or human intervention, and the PGA package can be manufactured with reduced cost. Generally, the diameter of the spheres is set to 0.5 - 2mm.

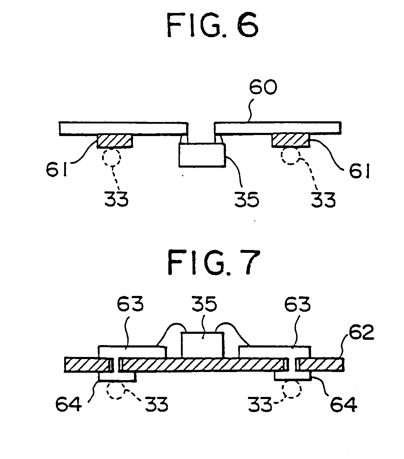

FIG. 6 shows another embodiment wherein the present invention is applied to the TAB (Tape Automated Bonding) process.

Referring to FIG. 6, the semiconductor chip 35 is mounted on a tape carrier 60 on which a conductor pattern 31 is formed. The spherical lead 33 is connected to this conductor pattern 31 on the carrier 60. In order to hold the spherical leads 33, a jig similar to the jig 36 of the first embodiment is used. As the process is readily derived from the previous description, further description of the present invention will be omitted.

FIG. 7 shows still other embodiment of the present invention, wherein the present invention is applied to the COB (Chip on Board) process.

Referring to FIG. 7, the semiconductor chip 35 is mounted on a board or substrate 62 that carries conductor patterns 63 and 64 respectively on the upper and lower major surfaces of the substrate 62. The upper conductor pattern 63 is connected to the lower conductor pattern 64 via a through hole formed in the substrate 62. The spherical leads 33 are mounted on the lower conductor pattern 63 as illustrated. In this case, too, the spheres 33 are held on the depressions formed in a jig similar to the jig 36. When sealing in the package body, on the other hand, another jig similar to the jig 43 may be used.

It should be noted that the leads used in the present invention is not limited to the spherical leads as described with reference to the first and second embodiments, but any lead may be used as long as it can easily roll on the jig when arranging the leads in a predetermined pattern. The arrangement of the lead is not limited to the row and column formation but any other pattern may be used. Further, the connection of the leads to the lead frame may be made by various welding processes other than the laser beam welding. For example, an electric welding may be used in the process of FIG.4(E).

Further, the present invention is not limited to the embodiments described heretofore, but various variations and modifications may be made without departing from the scope of the invention.

## Claims

1. A semiconductor device accomodated in a package, comprising a semiconductor chip (35);
a package body (32) for accomodating said semiconductor chip, said package body having a bottom surface; and
a plurality of terminal members (33) held in said package body in electrical connection to said semiconductor chip and projecting from said bottom surface,
each of said terminal members having a spherical shape and an identical size, and
each of said terminal members further having an exposed part defined by a circular boundary on said bottom surface, said circular boundary having a diameter smaller than the diameter of said terminal member.

2. A semiconductor device as claimed in claim 1, characterized in that each of said plurality of terminal members (33) projects from said bottom surface of said package body by substantially an equal distance (d).

3. A semiconductor device as claimed in claim 1, characterized in that said distance (d) of projection varies member by member with an amount less than 5 µm.

4. A semiconductor device as claimed in any of claims 1 to 3, wherein each of said terminal members (33) includes a solder alloy.

5. A method for fabricating a semiconductor device accomodated in a package, comprising the steps of:
mounting a semiconductor chip (35) on an interconnection member (34),
bonding a plurality of terminal members (33) having a spherical form and an identical size on said interconnection member according to a predetermined pattern, such that said terminal members establish an electrical and a mechanical connection to said interconnection member; and
molding said interconnection member together with said semiconductor chip and said terminal members in a resin package body (32) such that said terminal members are projected from said package body, wherein
said step of bonding said terminal members includes the steps of:
supplying said spherical terminal members (33) on a jig (36) that has an upper major surface, said upper major surface being formed with a plurality of depressions (39) arranged in accordance with a desired lead pattern, such that said terminal members settle in said depressions, said depressions being formed to be smaller than said terminal members such that a space (18) is formed between a terminal member and a corresponding depression when said terminal member is settled in said depression;
placing said interconnection member (34) on said jig such that said lower major surface of said interconnection member establishes a contact to said terminal members held in said depressions; and
establishing an electric connection and a mechanical connection between said terminal members held by said jig and said interconnection member.

6. A method as claimed in claim 5 wherein each depression (39) of said jig (36) is evacuated through a passage (40) formed in said jig in correspondence to and in communication with each of said depressions.

7. A method as claimed in any of claims 5 or 6, wherein said step of molding said interconnection member comprises the steps of:
placing said interconnection member (34) on which said terminal members (33) are connected electrically and mechanically, on a second jig (43b) that has an upper major surface formed with a plurality of depressions (45) arranged in accordance with said terminal members connected to said interconnection member, such that said terminal members are accepted in said depressions, said depressions being formed to be smaller than said terminal members such that a space (48) is formed between said terminal members and said depressions when said interconnection member is placed on said second jig; and
pouring a resin so as to bury said interconnection member in said resin together with said semiconductor chip held thereon.

8. A method as claimed in any of claims 5 to 7, wherein said step of establishing the electric connection and the mechanical connection comprises a welding process for welding said terminal members (33) upon said interconnection member (34).

## Patentansprüche

1. In einem Gehäuse untergebrachte Halbleitervorrichtung, umfassend einen Halbleiterchip (35);
einen Gehäusekörper (32) zum Unterbringen des Halbleiterchips, welcher Gehäusekörper eine Bodenfläche hat; und
eine Mehrzahl von Anschlußgliedern (33), die in dem Gehäusekörper in elektrischer Verbindung zu dem Halbleiterchip gehalten werden und von der Bodenfläche aus vorstehen,
wobei jedes der Anschlußglieder eine kugelförmige Form und eine identische Größe hat und
jedes der Anschlußglieder außerdem einen freiliegenden Teil, der durch eine kreisförmige Begrenzung auf der Bodenfläche definiert ist, hat, welche kreisförmige Begrenzung einen Durchmesser kleiner als der Durchmesser des Anschlußgliedes hat.

2. Halbleitervorrichtung nach Anspruch 1, dadurch gekennzeichnet, daß jedes der Mehrzahl von Anschlußgliedern (33) von der Bodenfläche des Gehäusekörpers um im wesentlichen einen gleichen Abstand (d) vorsteht.

3. Halbleitervorrichtung nach Anspruch 1, dadurch gekennzeichnet, daß der Vorstehabstand (d) Glied für Glied um einen Betrag von weniger als 5 µm variiert.

4. Halbleitervorrichtung nach einem der Ansprüche 1 bis 3, bei der jedes der Anschlußglieder (33) eine Lötlegierung umfaßt.

5. Verfahren zum Herstellen einer Halbleitervorrichtung, die in einem Gehäuse untergebracht ist, umfassend die Schritte:
Anbringen eines Halbleiterchips (35) auf einem Zwischenverbindungsglied (34),
Kontaktieren einer Mehrzahl von Anschlußgliedern (33), die eine kugelförmige Form und eine identische Größe haben, entsprechend einem vorbestimmten Muster auf dem Zwischenverbindungsglied, so daß die Anschlußglieder eine elektrische und eine mechanische Verbindung mit dem Zwischenverbindungsglied herstellen; und
Einformen des Zwischenverbindungsgliedes zusammen mit dem Halbleiterchip und den Anschlußgliedern in einen Harzgehäusekörper (32), so daß die Anschlußglieder von dem Gehäusekörper aus vorstehen, wobei
der Schritt eines Kontaktierens der Anschlußglieder die Schritte umfaßt:
Bringen der kugelförmigen Anschlußglieder (33) auf eine Absetzvorrichtung (36), die eine obere Hauptfläche hat, welche obere Hauptfläche mit einer Mehrzahl von Vertiefungen (39) ausgebildet ist, die entsprechend einem gewünschten Zuleitungsmuster angeordnet sind, so daß sich die Anschlußglieder in den Vertiefungen absetzen, welche Vertiefungen ausgebildet sind, kleiner als die Anschlußglieder zu sein, so daß zwischen einem Anschlußglied und einer entsprechenden Vertiefung ein Raum (18) gebildet wird, wenn sich das Anschlußglied in der Vertiefung abgesetzt hat;
Setzen des Zwischenverbindungsgliedes (34) auf die Absetzvorrichtung, so daß die untere Hauptfläche des Zwischenverbindungsgliedes zu den Anschlußgliedern, die in den Vertiefungen gehalten werden, einen Kontakt herstellt; und
Herstellen einer elektrischen Verbindung und einer mechanischen Verbindung zwischen den Anschlußgliedern, die von der Absetzvorrichtung gehalten werden, und dem Zwischenverbindungsglied.

6. Verfahren nach Anspruch 5, bei dem jede Vertiefung (39) der Absetzvorrichtung (36) durch einen Durchlaß (40), der in der Absetzvorrichtung in Entsprechung mit und in Verbindung mit jeder der Vertiefungen gebildet ist, evakuiert wird.

7. Verfahren nach einem der Ansprüche 5 oder 6, bei dem der Schritt des Einformens des Zwischenverbindungsgliedes die Schritte umfaßt:
Setzen des Zwischenverbindungsgliedes (34), auf dem die Anschlußglieder (33) elektrisch und mechanisch angeschlossen sind, auf eine zweite Absetzvorrichtung (43b), die eine obere Hauptfläche hat, die mit einer Mehrzahl von Vertiefungen (45) ausgebildet ist, welche in Übereinstimmung mit den Anschlußgliedern, die mit dem Zwischenverbindungsglied verbunden sind, angeordnet sind, so daß die Anschlußglieder in den Vertiefungen aufgenommen werden, welche Vertiefungen ausgebildet sind, kleiner als die Anschlußglieder zu sein, so daß ein Raum (48) zwischen den Anschlußgliedern und den Vertiefungen gebildet wird, wenn das Zwischenverbindungsglied auf die zweite Absetzvorrichtung gesetzt wird; und
Gießen eines Harzes, um so das Zwischenverbindungsglied zusammen mit dem darauf gehaltenen Halbleiterchip in dem Harz einzugraben.

8. Verfahren nach einem der Ansprüche 5 bis 7, bei dem der Schritt des Herstellens der elektrischen Verbindung und der mechanischen Verbindung einen Schweißprozeß zum Schweißen der Anschlußglieder (33) auf das Zwischenverbindungsglied (34) umfaßt.

## Revendications

1. Composant semi-conducteur logé dans un encapsulage, comprenant une plaquette semi-conductrice (35) ;
- un corps d'encapsulage (32) pour loger ladite plaquette semi-conductrice, ledit corps d'encapsulage ayant une surface inférieure ; et
- une pluralité d'éléments formant bornes (33) tenus dans ledit corps d'encapsulage, en connexion électrique avec ladite plaquette semi-conductrice et se projetant depuis ladite surface de fond,
chacun desdits éléments formant bornes ayant une forme sphérique et une taille identique et,
chacun desdits éléments formant bornes ayant en outre une partie exposée définie par une limite circulaire de ladite surface de fond, ladite limite circulaire ayant un diamètre inférieur au diamètre dudit élément formant borne.

2. Composant semi-conducteur selon la revendication 1, caractérisé en ce que chacun desdits éléments formant bornes de ladite pluralité (33) se projette depuis ladite surface de fond dudit corps d'encapsulage sensiblement sur une distance égale (d).

3. Composant semi-conducteur selon la revendication 1, caractérisé en ce que ladite distance (d) de projection varie d'élément à élément d'une valeur inférieure à 5 microns.

4. Composant semi-conducteur selon l'une quelconque des revendications 1 à 3, dans lequel chacun desdits éléments formant borne (33) inclut un alliage de soudure.

5. Procédé pour fabriquer un composant semi-conducteur logé dans un encapsulage, comprenant les étapes consistant à :
- monter une plaquette semi-conductrice (35) sur un élément d'interconnexion (34),
- joindre une pluralité d'éléments formant bornes (33) ayant une forme sphérique et une taille identique sur ledit élément d'interconnexion selon un motif prédéterminé, de telle matière que lesdits éléments formant bornes établissent une connexion électrique et mécanique avec ledit élément d'interconnexion ; et
- mouler ledit élément d'interconnexion ensemble avec ladite plaquette semi-conductrice et lesdits éléments formant bornes dans un corps d'encapsulage en résine (32) de telle manière que lesdits éléments formant bornes se projettent depuis ledit corps d'encapsulage ;
dans lequel :
ladite étape consistant à joindre lesdits éléments formant bornes inclut les opérations consistant à :
- fournir lesdits éléments formant bornes sphériques (33) sur une monture (36) qui présente une surface principale supérieure, ladite surface principale supérieure étant formée avec une pluralité de dépressions (39) agencées conformément à un motif désiré, de telle façon que lesdits éléments formant bornes se mettent en place dans lesdites dépressions, lesdites dépressions étant formées de façon à être plus petites que lesdits éléments formant bornes de manière à former un espace (18) entre un élément formant borne et une dépression correspondante lorsque ledit élément formant borne est mis en place dans ladite dépression ;
- placer ledit élément d'interconnexion (34) sur ladite monture de manière que ladite surface principale inférieure dudit élément d'interconnexion établit un contact avec lesdits éléments formant bornes tenus dans lesdites dépressions ; et
- établir une connexion électrique et une connexion mécanique entre lesdits éléments formant bornes tenus par ladite monture et ledit élément d'interconnexion.

6. Procédé selon la revendication 5, dans lequel chaque dépression (39) de ladite monture (36) est évacuée via un passage (40) formé dans ladite monture en correspondance et en communication avec chacune des dépressions.

7. Procédé selon l'une ou l'autre des revendications 5 et 6, dans lequel ladite étape consistant à mouler ledit élément d'interconnexion comprend les étapes consistant à:
- placer ledit élément d'interconnexion (34), sur lequel lesdits éléments formant bornes (33) sont connectés de manière électrique et mécanique, sur une seconde monture (43b) qui présente une surface principale supérieure formée avec une pluralité de dépressions (45) agencées conformément auxdits éléments formant bornes connectés auxdits éléments d'interconnexion, de manière que lesdits éléments formant bornes soient acceptés dans lesdites dépressions, lesdites dépressions étant formées de manière à être plus petites que lesdits éléments formant bornes, de sorte qu'il se forme un espace (48) entre lesdits éléments formant bornes et lesdites dépressions lorsque ledit élément d'interconnexion est placé sur ladite seconde monture ; et
- verser une résine de manière à noyer ledit élément d'interconnexion dans ladite résine ensemble avec ladite plaquette semi-conductrice tenue sur celui-ci.

8. Procédé selon l'une quelconque des revendications 5 à 7, dans lequel ladite étape consistant à établir la connexion électrique et la connexion mécanique comprend un processus de soudage pour souder lesdits éléments formant bornes (33) sur ledit élément d'interconnexion (34).
